# EUROPÄISCHE PATENTSCHRIFT

(11) **EP 0 311 605 B1**
(45) Veröffentlichungstag und Bekanntmachung des Hinweises auf die Patenterteilung: **31.03.1993**
(21) Anmeldenummer: 87902434.7
(22) Anmeldetag: 09.05.1987
(51) Int. Cl.: H03K 17/04, H01L 27/08

(54) **TRANSISTORANORDNUNG MIT EINEM ENDSTUFENTRANSISTOR**
TRANSISTOR ARRANGEMENT WITH AN OUTPUT TRANSISTOR
MONTAGE DE TRANSISTORS COMPORTANT UN TRANSISTOR DE SORTIE

(30) Priorität: 26.06.1986 DE 3621396
(43) Veröffentlichungstag der Anmeldung: 19.04.1989
(73) Patentinhaber: ROBERT BOSCH GMBH, 70442 Stuttgart (DE)
(72) Erfinder: FLOHRS, Peter, D-7410 Reutlingen 11 (DE); HEYKE, Klaus, D-7410 Reutlingen (DE); MICHEL, Hartmut, D-7410 Reutlingen (DE); NELLE, Ulrich, D-7419 Sonnenbühl 1 (DE)
(86) Internationale Anmeldenummer: DE8700217
(87) Internationale Veröffentlichungsnummer: WO8800413

(56) Entgegenhaltungen:
- DE-A- 3 247 006
- US-A- 4 021 687
- Radio Fernsehen Elektronik, Band 33, Nr. 1, Januar 1984 (Berlin, DD), Gleisberg et al., "Basisansteuerung von Hochvolt-Schalttransistoren", Seiten 47-48
- R. BLADOWSKI: "Integrierte Analogschaltungen"; 1970, Franckh'sche Verlagshandlung, W. Keller & co, Stuttgart, Seite 13

## Beschreibung

Die Erfindung betrifft eine monolithisch integrierte Transistoranordnung nach dem Oberbegriff des unabhängigen Anspruchs 1.

Aus der DE-OS 34 39 366 ist bereits eine Transistoranordnung mit einem als Darlingtontransistor ausgebildeten Endstufentransistor bekannt. Die Transistoranordnung dient als Zündungsendstufe zur Ansteuerung von Transistorzündanlagen in Kraftfahrzeugen. Hierfür ist in den Kollektor-Emitter-Kreis des Leistungstransistors die Primärwicklung einer Zündspule geschaltet. Damit eine möglichst hohe Zündspannung an der Sekundärseite der Zündspule erreicht wird, ist es nach dem Induktionsgesetz notwendig, daß der Strom durch die Primärwicklung der Zündspule möglichst rasch abgeschaltet wird.

Bekanntlich vergeht beim Abschalten eines Transistors eine gewisse Zeit, bis der Transistor nach Beendigung der Basisansteuerung seine volle Sperrfähigkeit erlangt. Diese Abschaltzeit wird vor allem durch in der Basisregion des Transistors gespeicherte Ladungsträger verursacht. Häufig spricht man auch von einer geladenen Kollektor-Basis-Kapazität des Transistors. Die Abschaltzeit des Transistors ist daher verhältnismäßig lang, wenn zum Abschalten des Kollektorstroms einfach der Basisstrom unterbrochen wird. Sie läßt sich deutlich verkürzen, wenn die im Transistor gespeicherten Ladungsträger mit Hilfe einer Umkehrung des Basisstroms ausgeräumt werden. Entsprechendes gilt auch für Transistoren in Darlington-Schaltung, wobei aber eine minimale Schaltzeit nur dann erreicht werden kann, wenn nicht nur die Basis des Treibertransistors, sondern auch die Basis des Leistungstransistors ausgeräumt wird. In vielen Anwendungsfällen ist es aus schaltungstechnischen Gründen allerdings nicht möglich, eine Umkehrung des Basisstroms zur Erreichung eines raschen Abschaltvorgangs durchzuführen.

Aus dem Aufsatz von R. Bladowski "Integrierte Analogschaltungen", 1970, Franckh'sche Verlagsbuchhandlung, W. Keller & Co., Stuttgart, Seite 13, ist es ferner bereits bekannt, einem PNP-Lateraltransistor zur Erhöhung seiner Stromverstärkung einen NPN-Vertikaltransistor in der Weise nachzuschalten, daß der Kollektor des NPN-Transistors an den Emitter und die Basis des NPN-Transistors an den Kollektor des PNP-Transistors angeschlossen wird.

Darüber hinaus ist aus der DE-OS 32 47 006, Figuren 3 bis 5, bereits eine monolithisch integrierte Transistoranordnung nach dem Oberbegriff des unabhängigen Anspruchs 1 bekannt, bei der zur Verkürzung der Ausschaltzeit des Endstufen-Darlington-Transistors der Ausräumtransistor mit seinem Kollektor unmittelbar an den Emitter des Leistungstransistors angeschlossen ist. Diese Anordnung hat den Nachteil, daß die durch den Ausräumtransistor bewirkte Verkürzung der Ausschaltzeit des Endstufen-Darlington-Transistors in vielen Anwendungsfällen noch nicht ausreichend ist.

Aus der US-PS 4 021 687 ist weiterhin eine monolithisch integrierte Transistoranordnung mit einem als Vertikalstruktur ausgebildeten npn-Endstufentransistor, einem als Horizontalstruktur ausgebildeten pnp-Ausräumtransistor und einem als Vertikalstruktur ausgebildeten npn-Folgetransistor bekannt. Bei dieser bekannten Transistoranordnung sind die Basis des Endstufentransistors, der Emitter des Ausräumtransistors und der Kollektor des Folgetransistors elektrisch miteinander verbunden. Ferner sind der Kollektor des Endstufentransistors und die Basis des Ausräumtransistors elektrisch miteinander verbunden. Weiterhin ist bei dieser bekannten Transistoranordnung der Kollektor des Ausräumtransistors an die Basis des Folgetransistors und der Emitter des Endstufentransistors an den Emitter des Folgetransistors angeschlossen. Die bekannte Tansistoranordnung ist in Bipolar-Epitaxialtechnik mit einem p-leitenden Substrat und einer auf das Substrat aufgebrachten n-leitenden Epitaxialschicht ausgeführt, wobei die n-leitende Epitaxialschicht durch p⁺ -leitende Isolierungsdiffusionszonen in eine Vielzahl von Inseln unterteilt ist. In einer dieser Inseln sind der als Vertikalstruktur ausgebildete npn-Endstufentransistor und der als Horizontalstruktur ausgebildete pnp-Ausräumtransistor gemeinsam untergebracht. Der als Einzeltransistor ausgeführte Endstufentransistor wird dabei durch den innerhalb der Insel abgetrennten Bereich der Epitaxialschicht als Kollektorzone, eine in diesen Bereich eindiffundierte Zone mit Basisdiffusion als Basiszone und eine in diese Basiszone eindiffundierte Zone mit Emitterdiffusion als Emitterzone gebildet. Der Ausräumtransistor, der eine zum Endstufentransistor komplementäre Zonenfolge aufweist, ist innerhalb derselben Insel derart ausgebildet, daß die in die Insel eindiffundierte Basiszone des Endstufentransistors gleichzeitig die Emitterzone des Ausräumtransistors bildet, daß die Basiszone des Ausräumtransistors durch den innerhalb der Insel abgetrennten Bereich der Epitaxialschicht gebildet wird und daß als Kollektorzone für den Ausräumtransistor innerhalb der Insel eine weitere Zone mit Basisdiffusion vorgesehen ist. Diese bekannte Transistoranordnung hat den Nachteil, daß bei ihr der npn-Folgetransistor innerhalb der Epitaxialschicht als Vertikalstruktur in einer weiteren Insel untergebracht ist, die von derjenigen Insel, die den Endstufentransistor und den Ausräumtransistor enthält, in der bei der Bipolar-Epitaxialtechnik üblichen Weise durch eine p⁺-leitende Isolierungsdiffusionszone elektrisch isoliert ist.

### Vorteile der Erfindung

Die erfindungsgemäße monolithisch integrierte Transistoranordnung mit den Merkmalen des unabhängigen Anspruchs 1 hat den Vorteil, daß infolge der Ausbildung des Folgetransistors als Horizontalstruktur innerhalb der Kollektorzone des Ausräumtransistors für die Unterbringung des Folgetransistors keine weitere Fläche im Layout benötigt wird, so daß auf die Anwendung der Epitaxialtechnik verzichtet werden kann. Weitere Vorteile ergeben Sich aus den abhängigen Ansprüchen 2 bis 4 und aus der Beschreibung.

### Zeichnung

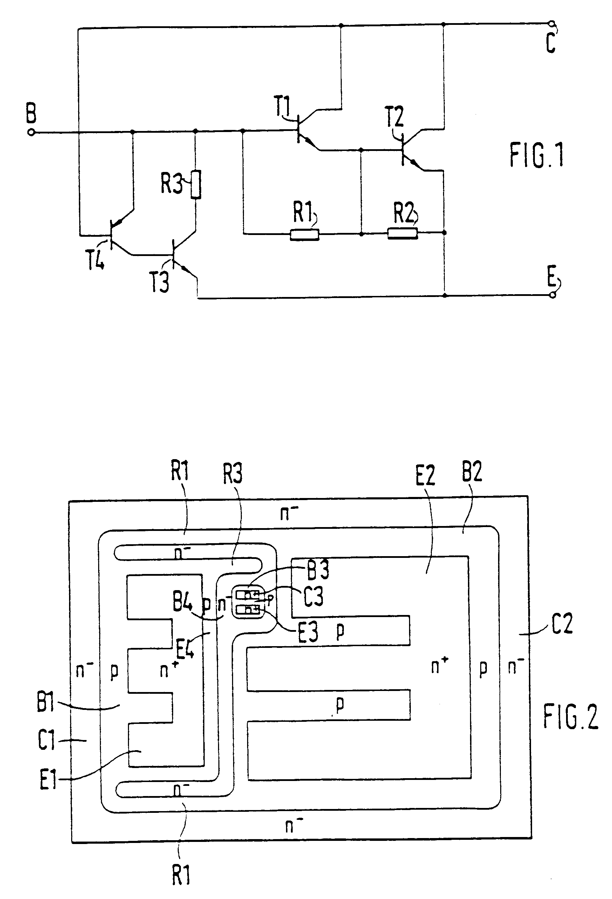

Die Erfindung wird anhand der Zeichnung näher erläutert. Die Figur 1 zeigt das Schaltbild einer Transistoranordnung, die aus einem Endstufen-Darlington-Transistor, einem Ausräumtransistor und einem Folgetransistor besteht. Figur 2 zeigt eine gemäß der Erfindung ausgestaltete Diffusionsstruktur der Transistoranordnung nach Figur 1 auf einem Substrat.

### Beschreibung der Erfindung

In Figur 1 ist das Schaltbild einer Transistoranordnung dargestellt, die eine Basisklemme B, eine Kollektorklemme C und eine Emitterklemme E aufweist. Die Transistoranordnung weist einen Endstufen-Darlington-Transistor, bestehend aus einem Treibertransistor T1 und einem Leistungstransistor T2, auf. Die Kollektoren der Transistoren T1, T2 sind gemeinsam an die Kollektorklemme C gelegt. Die Basis des Treibertransistors T1 führt zur Basisklemme B, während sein Emitter mit der Basis des Leistungstransistors T2 verbunden ist. Der Emitter des Leistungstransistors T2 führt dagegen zur Emitterklemme E. Parallel zur Basis-Emitter-Diode des Treibertransistors T1 ist ein Widerstand R1 geschaltet, während entsprechend parallel Zur Basis-Emitter-Diode des Leistungstransistors T2 ein Widerstand R2 geschaltet ist. Ein Widerstand R3 führt von der Basisklemme B zum Kollektor eines Transistors T3, der als Folgetransistor von einem Ausräumtransistor T4 angesteuert wird. Hierfür ist der Folgetransistor T3 mit der Basis an den Kollektor des Ausräumtransistors T4 angeschlossen, während der Emitter des Folgetransitors T3 an der Emitterklemme E liegt. Der Emitter des Ausräumtransistors T4 ist mit der Basisklemme B verbunden, während seine Basis mit der Kollektorklemme C verbunden ist. Der Leitfähigkeitstyp des Transistors T4 ist invers zum Leitfähigkeitstyp der Transistoren T1, T2, T3.

Die Funktionsweise des Endstufen-Darlington-Transistors T1, T2 und der Widerstände R1, R2 ist dem Fachmann bekannt und zur Vereinfachung der Darstellung darum hier nicht näher erläutert.

Die Ausschaltzeit eines Leistungstransistors hängt stark von der Höhe der Übersteuerung oder Sättigung im eingeschalteten Zustand ab. Die Übersteuerung ist abhängig von der Verstärkung des Leistungstransistors und unterliegt daher wie diese starken Exemplarstreuungen. Durch den Ausräumtransistor T4 und den Folgetransistor T3 kann der Treibertransistor T1 zwar voll aufgesteuert werden, er gerät jedoch nicht in eine Übersteuerung. Denn wenn das Potential an der Kollektorklemme C in die Nähe des Emitterpotentials des Treibertransistors T1 gerät, wird der Ausräumtransistors T4 aufgesteuert und damit der Folgetransistor T3. Daraufhin fließt über den Widerstand R3 und die Kollektor-Emitter-Strecke des Transistors T3 Basisstrom von der Basis des Treibertransistors T1 ab, so daß einer Übersteuerung entgegengewirkt wird.

Nach dem Abschalten des Basisstroms an der Basisklemme B sind noch Ladungsträger in den Basisregionen der Transistoren vorhanden. Die gespeicherte Ladung in der Basisregion des Folgetransistors T3 führt dazu, daß noch eine gewisse Zeit lang der Transistor T3 aufgesteuert bleibt. Dadurch wird auch die Basisregion des Transistors T1 und über die Widerstände R1 und R2 die Basisregion des Transistors T2 ausgeräumt. Es ist damit eine maximale Verkürzung der Ausschaltzeit der gesamten Transistoranordnung erreicht.

In Figur 2 ist eine Diffusionsstruktur einer monolithischen Integration der in Figur 1 gezeigten Schaltung dargestellt, wie sie vor Aufbringen des metallischen Verbindungsnetzwerks auf der Oberfläche unter einem Mikroskop erscheinen könnte. Das Substrat zur Bildung des gemeinsamen Kollektors ist negativ dotiert und weist eine nicht dargestellte Rückseitenmetallisierung für den elektrischen Anschluß mit der Kollektorklemme C auf. Der rechte äußere Teil der in Figur 2 gezeigten Diffusionsstruktur stellt dementsprechend den Kollektorbereich C2 des Leistungstransistors T2 dar, während der linke äußere Teil entsprechend die Kollektorzone C1 des Treibertransistors T1 darstellt. In die Kollektorbereiche werden anschließend positiv dotierte Basiszonen eingebracht. Die geometrische Form der Basiszonen entsteht durch Maskierung der nicht zu verändernden Bereiche. Und zwar entstehen gleichzeitig die Basiszone B1 des Treibertransistors T1 auf der linken Seite der Figur 2, die Basiszone B2 des Leistungstransistors T2 auf der rechten Seite der Figur 2 und es entsteht die Basiszone B3 des Folgetransistors T3, die zwischen den Basiszonen B1, B2 angeordnet ist. Die Basiszone B1 ist über zwei schmale außenliegende Stege mit der Basiszone B2 verbunden. Durch die Stege wird der Widerstand R1 gebildet. Ein der Basiszone B3 benachbarter Teil der Basiszone B1 stellt gleichzeitig den Emitter E4 des Ausräumtransitors T4 dar. Der dazwischenliegende negativ dotierte Bereich des Kollektorsubtrats stellt die Basiszone B4 des Ausräumtransistors T4 dar. Der Koilektor des Ausräumtransistors T4 wird auf diese Weise durch die Basiszone B3 des Folgetransistors T3 dargestellt, ohne daß eine gesonderte Diffusion notwendig wäre.

In die positiv dotierten Basiszonen B1, B2, B3 werden in bekannter Weise stark negativ dotierte Emitterzonen eingebracht. Auf der linken Seite der Figur 2 ist der Emitter E1 des Treibertransistors T1 dargestellt. Auf der rechten Seite ist entsprechend der Emitter E2 des Leistungstransistors T2 dargestellt. Kollektor C3 und Emitter E3 des Folgetransistors T3 werden durch zwei benachbarte kleine Zonen innerhalb der Basiszone B3 gebildet. Der Widerstand R3 wird durch eine kleine Ausbuchtung der Basiszone B1 gebildet. Er wird an die Kollektorzone C3 des Folgetransistors T3 mit einer in Figur 2 nicht dargestellten kleinen metallischen Verbindung angeschlossen. Der in Figur 2 nicht dargestellte Widerstand R2 entsteht durch einen kleinen Kurzschluß an einem Teil des an der Oberfläche des Substrats liegenden Basis-Emitter-Übergangs des Leistungstransistors T2. Durch die Integration des Darlington-Endstufentransistors als Vertikalstruktur und das Ausräumtransistors mit Folgetransistor als benachbarte Horizontalstruktur wird also ein besonders geringer Flächenbedarf auf dem Substrat erreicht.

## Patentansprüche

1. In einem Substrat untergebrachte monolithisch integrierte Transistoranordnung mit einem Endstufen-Darlington-Transistor (T1, T2), bestehend aus einem Treibertransistor (T1) und einem Leistungstransistor (T2), wobei der Endstufen-Darlington-Transistor (T1, T2) eine erste Zonenfolge aufweist und in dem Substrat als Vertikalstruktur derart ausgebildet ist, daß die Basiszone des Treibertransistors (T1) und die Basiszone des Leistungstransistors (T2) von einer ersten Hauptoberfläche des Substrats aus in das Substrat als eine erste Zone (B1) und eine zweite Zone (B2) mit Basisdiffusion eingebracht sind und daß die Emitterzone (E1) des Treibertransistors (T1) und die Emitterzone (E2) des Leistungstransistors (T2) von derselben Hauptoberfläche aus jeweils in die zugehörige Basiszone (B1, B2) eingebracht sind, und mit einem mit seinem Emitter an die Basis und mit seiner Basis an den Kollektor des Treibertransistors (T1) angeschlossenen Ausräumtransistor (T4), der eine zweite, zum Endstufen-Darlington-Transistor (T1, T2) komplementäre Zonenfolge aufweist und in dem Substrat als Horizontalstruktur derart ausgebildet ist, daß die Basiszone (B1) des Treibertransistors (T1) gleichzeitig die Emitterzone (E4) des Ausräumtransistors (T4) bildet, daß die Basiszone des Ausräumtransistors (T4) durch das Substrat gebildet wird und daß als Kollektorzone für den Ausräumtransistor (T4) eine dritte Zone (B3) mit Basisdiffusion vorgesehen ist, dadurch gekennzeichnet, daß der Kollektor des Ausräumtransistors (T4) über die Basis-Emitter-Diode eines Folgetransistors (T3) mit dem Emitter (E) des Leistungstransistors (T2) verbunden ist, daß der Kollektor (C3) des Folgetransistors (T3) mit der Basis (B) des Treibertransistors (T1) verbunden ist und daß der Folgetransistor (T3) eine zum Ausräumtransistor (T4) komplementäre Zonenfolge aufweist und in der als Kollektorzone für den Ausräumtransistor (T4) dienenden dritten Zone (B3) mit Basisdiffusion als Horizontalstruktur derart ausgebildet ist, daß die Kollektorzone (B3) des Ausräumtransistors (T4) gleichzeitig die Basiszone des Folgetransistors (T3) bildet und daß die Emitterzone (E3) und die Kollektorzone (C3) des Folgetransistors (T3) in die genannte dritte Zone (B3) mit Basisdiffusion als weitere Zonen mit Emitterdiffusion eindiffundiert sind.

2. Transistoranordnung nach Anspruch 1, dadurch gekennzeichnet, daß zwischen den Kollektor (C3) des Folgetransistors (T3) und die Basis (B) des Treibertransistors (T1) ein Schutzwiderstand (R3) geschaltet ist, der durch eine Ausbuchtung der Basiszone (B1) des Treibertransistors (T1) gebildet wird.

3. Transistoranordnung nach Anspruch 1 oder 2, dadurch gekennzeichnet, daß parallel zu der Basis-Emitter-Diode des Treibertransistors (T1) ein erster Hilfswiderstand (R1) geschaltet ist, der dadurch gebildet wird, daß die Basiszone (B1) des Treibertransistors (T1) und die Basiszone (B2) des Leistungstransistors (T2) über zwei schmale Stege aus Basismaterial miteinander zusammenhängen.

4. Transistoranordnung nach einem der Ansprüche 1 bis 3, dadurch gekennzeichnet, daß parallel zur Basis-Emitter-Diode des Leistungstransistors (T2) ein zweiter Hilfswiderstand (R2) geschaltet ist, der durch einen Kurzschluß an einem Teil des an der Oberfläche des Substrats liegenden Basis-Emitter-Übergangs des Leistungstransistors (T2) gebildet wird.

## Claims

1. Monolithically integrated transistor arrangement accommodated in a substrate and having a output-stage Darlington pair (T1, T2) consisting of a drive transistor (T1) and a power transistor (T2), the output-stage Darlington pair (T1, T2) having a first zone sequence and being constructed in the substrate as a vertical structure such that the base zone of the drive transistor (T1) and the base zone of the power transistor (T2) are introduced into the substrate starting from a first main surface of the substrate as a first zone (B1) and a second zone (B2) having base diffusion, and that the emitter zone (E1) of the drive transistor (T1) and the emitter zone (E2) of the power transistor (T2) are introduced starting from the same main surface into the associated base zone (B1, B2), respectively, and having a depletion transistor (T4), which is connected with its emitter to the base and with its base to the collector of the drive transistor (T1) and has a second zone sequence which is complementary with respect to the output-stage Darlington pair (T1, T2) and is constructed in the substrate as a horizontal structure in such a way that the base zone (B1) of the drive transistor (T1) simultaneously forms the emitter zone (E4) of the depletion transistor (T4), that the base zone of the depletion transistor (T4) is formed by the substrate, and that a third zone (B3) having base diffusion is provided as collector zone for the depletion transistor (T4), characterised in that the collector of the depletion transistor (T4) is connected via the base-emitter diode of a follow transistor (T3) to the emitter (E) of the power transistor (T2), in that the collector (C3) of the follow transistor (T3) is connected to the base (B) of the drive transistor (T1), and in that the follow transistor (T3) has a zone sequence that is complementary with respect to the depletion transistor (T4) and is constructed in the third zone (B3) having base diffusion and serving as collector zone for the depletion transistor (T4) as a horizontal structure in such a way that the collector zone (B3) of the depletion transistor (T4) simultaneously forms the base zone of the follow transistor (T3) and that the emitter zone (E3) and the collector zone (C3) of the follow transistor (T3) are diffused into the said third zone (B3) having base diffusion as further zones having emitter diffusion.

2. Transistor arrangement according to Claim 1, characterised in that there is connected between the collector (C3) of the follow transistor (T3) and the base (B) of the drive transistor (T1) a protective resistor (R3) which is formed by a projection of the base zone (B1) of the drive transistor (T1).

3. Transistor arrangement according to Claim 1 or 2, characterised in that there is connected in parallel to the base-emitter diode of the drive transistor (T1) a first auxiliary resistor (R1), which is formed by arranging that the base zone (B1) of the drive transistor (T1) and the base zone (B2) of the power transistor (T2) are joined to one another via two narrow webs made from the base material.

4. Transistor arrangement according to one of Claims 1 to 3, characterised in that there is connected in parallel to the base-emitter diode of the power transistor (T2) a second auxiliary resistor (R2) which is formed by a short circuit on the part of the base-emitter transition of the power transistor (T2) situated on the surface of the substrate.

## Revendications

1. Montage de transistors placé sur un substrat et intégré de façon monolithique avec un transistor de sortie Darlington (T1, T2), composé d'un transistor d'attaque (T1) et d'un transistor de puissance (T2), montage dans lequel le transistor de sortie Darlington (T1, T2) a une première série de zones et est réalisé dans le substrat en structure verticale de manière que la zone de base du transistor d'attaque (T1) et la zone de base du transistor de puissance (T2) sont mises en place à partir d'une première surface principale du substrat dans le substrat comme une première zone B1 et une deuxième zone B2 avec diffusion de base et que la zone d'émetteur (E1) du transistor d'attaque T1 et la zone d'émetteur (E2) du transistor de puissance (T2) sont mises en place à partir de la même surface principale respectivement dans la zone de base (B1, B2) correspondante, et avec un transistor de décharge (T4) relié par son émetteur à la base et par sa base au collecteur du transistor d'attaque (T1), transistor (T4) qui a une deuxième série de zones complémentaire par rapport au transistor de sortie Darlington (T1, T2) et est réalisé dans le substrat en structure horizontale, de façon que la zone de base (B1) du transistor d'attaque (T1) constitue en même temps la zone d'émetteur (E4) du transistor de décharge (T4) que la zone de base du transistor de décharge (T4) soit formée par le substrat et que comme zone de collecteur pour le transistor de décharge (T4) soit prévue une troisième zone (B3) avec diffusion de base, montage de transistor caractérisé en ce que
- le collecteur (C3) du transistor séquentiel (T3) est relié à la base (B) du transistor d'attaque (T1) et
- le transistor séquentiel (T3) comprend une série de zones complémentaires par rapport au transistor de décharge (T4) et est réalisé en structure horizontale dans la troisième zone (B3) servant de zone de collecteur, pour le transistor de décharge (T4) avec diffusion de base de manière, que la zone de collecteur (B3) du transistor de décharge (T4) constitue en même temps la zone de base du transistor séquentiel (T3) et que la zone d'émetteur (E3) et la zone de collecteur (C3) du transistor séquentiel (T3) soient diffusées à l'intérieur de la troisième zone nommée (B3) avec diffusion de base comme d'autres zones avec diffusion d'émetteur.

2. Montage de transistors selon la revendication 1, caractérisé en ce que entre le collecteur (C3) du transistor séquentiel (T3) et la base (B) du transistor d'attaque (T1) est branchée une résistance de protection (R3), qui est formée par une courbure de la zone de base (B1) du transistor d'attaque (T1).

3. Montage de transistor selon la revendication 1 ou 2 caractérisé en ce qu'en parallèle à la diode-émetteur-base du transistor d'attaque (T1) est branchée une première résistance auxiliaire (R1), qui est réalisée, par le fait que la zone de base (B1) du transistor d'attaque (T1) et la zone de base (B2) du transistor de puissance (T2) sont liées ensemble par deux barrettes étroites en matériau de base.

4. Montage de transistor selon une des revendications 1 à, 3, caractérisé en ce que parallèlement à la diode-émetteur-base du transistor de puissance (T2) est branchée une deuxième résistance auxiliaire (R2), qui est formée par un court circuit sur une partie de la transition émetteur-base du transistor de puissance (T2), située sur la surface du substrat.
